# EUROPEAN PATENT APPLICATION

(11) **EP 4 539 272 A1**
(43) Date of publication of application: **16.04.2025**
(21) Application number: 24204916.1
(22) Date of filing: 07.10.2024
(51) Int. Cl.: H01S 5/062, H01S 5/065, H01S 5/0687, H01S 5/12, H01S 5/14, H01S 5/50, H01S 5/00, H01S 5/028, H01S 5/0683, H01S 5/10

(54) **INTEGRATED NARROW LINEWIDTH LASER SOURCE WITH OPTICAL AMPLIFIER**

(30) Priority: 12.10.2023 US 202363589771 P
(71) Applicant: Denselight Semiconductors Pte Ltd, Singapore 498831 (SG)
(72) Inventor: LAM, Yee Loy, 426094 Singapore (SG); SHU, Huade, Shanghai, 201419 (CN); CHOO, Lay Cheng, 520893 Singapore (SG); KOH, Long Cheng, 600122 Singapore (SG); CHAN, Yuen Chuen, 138678 Singapore (SG)
(74) Representative: Cabinet Chaillot

(57) **Abstract**

An integrated device for optical power control and stabilization is provided. The integrated device includes a laser source and an optical amplifier operably coupled to the laser source. The laser source emits a light having a narrow optical linewidth at an initial output power. The optical amplifier, for example, a semiconductor optical amplifier, receives and amplifies the light from the laser source, and emits the amplified light. The optical amplifier controls a resultant output power of the emitted amplified light to a configurable level while maintaining the narrow optical linewidth in the emitted amplified light and a lasing wavelength of the laser source constant. Based on operation with a reverse bias, the optical amplifier also operates as an optical absorber and suppresses the received light having the narrow optical linewidth without requiring a change to a drive current of the laser source.

## Description

### CROSS-REFERENCE TO RELATED APPLICATIONS

This application claims priority to and the benefit of the provisional patent application titled "Integrated Narrow Linewidth Laser Source with Semiconductor Optical Amplifier for Optical Power Control and Stabilization", application number 63/589,771, filed in the United States Patent and Trademark Office on October 12, 2023, which is incorporated herein by reference in its entirety.

### FIELD

Various embodiments of the disclosure relate generally to optical circuits. More particularly, various embodiments of the disclosure relate to an integrated narrow linewidth laser source with an optical amplifier for optical power control and stabilization.

### BACKGROUND

Various laser applications may require laser sources that emit light with a substantially narrow optical linewidth, that is, with a narrow optical spectrum. These laser sources may be referred to as "narrow linewidth laser sources". These narrow linewidth laser sources may have various applications including, for example, Frequency-Modulated Continuous-Wave (FMCW) coherent communications, photonic sensing, or the like. Depending on operational requirements, there is often a need to set, control, and stabilize an output power of a light emitted by a narrow linewidth laser source to a particular level in accordance with environmental conditions.

Conventional narrow linewidth laser sources may include, for example, distributed feedback lasers and gain chip-based external cavity lasers. The optical linewidth, output power, and lasing wavelength of these narrow linewidth laser sources may depend on a drive current applied to the distributed feedback lasers and gain chips of the external cavity lasers. Therefore, when the drive current is varied to control and stabilize the output power of the light emitted by these narrow linewidth laser sources, the optical linewidth and the lasing wavelength may also be affected and altered. Further, during the process of controlling and stabilizing the output power of the emitted light, the performance of the narrow linewidth laser sources may be affected due to a change in the optical linewidth of the emitted light and the change in the lasing wavelength of the narrow linewidth laser sources. The optical linewidth and the lasing wavelength of the narrow linewidth laser sources must, therefore, be maintained constant for various high-precision laser applications.

In light of the foregoing, there is a need for a technical solution that overcomes the above-mentioned problems.

### SUMMARY

Integrated devices and methods for controlling and stabilizing an output power of a narrow linewidth laser source without any impact to a narrow optical linewidth and a lasing wavelength of the narrow linewidth laser source are provided substantially as shown in, and/or described in connection with, at least one of the figures, as set forth more completely in the claims.

These and other features and advantages of the present disclosure may be appreciated from a review of the following detailed description of the present disclosure, along with the accompanying drawings in which like reference numerals refer to like parts throughout.

### BRIEF DESCRIPTION OF THE DRAWINGS

The accompanying drawings illustrate the various embodiments of devices, methods, and other aspects of the disclosure by way of example. As such, the embodiments herein are not limited to the specific components, structures, and methods disclosed herein. Further, the terms "first", "second", and "third" are used herein for descriptive purposes only and are not to be construed to indicate or imply relative importance.

Various embodiments of the present disclosure are illustrated by way of example and not limitation in the figures of the accompanying drawings, in which:
FIG. 1 is a diagram that illustrates an integrated device for optical power control and stabilization, in accordance with an embodiment of the present disclosure;
FIG. 2 is a graphical representation that illustrates a spectral distribution of a narrow linewidth laser source and an amplified spectrum thereof, in accordance with an embodiment of the present disclosure;
FIG. 3 is a diagram that illustrates an integrated device including a Distributed FeedBack (DFB) laser and a Semiconductor Optical Amplifier (SOA) arranged in a first assembly configuration, in accordance with an embodiment of the present disclosure;
FIG. 4 is a diagram that illustrates an integrated device including a DFB laser and an SOA arranged in a second assembly configuration, in accordance with an embodiment of the present disclosure;
FIG. 5A is a diagram that illustrates an integrated device including a DFB laser and an SOA arranged in a third assembly configuration, in accordance with an embodiment of the present disclosure;
FIGS. 5B and 5C are diagrams that illustrate configurations of a passive angled waveguide of the DFB laser in the integrated device shown in FIG. 5A, for spot-size conversion;
FIG. 6 is a diagram that illustrates an integrated device including a gain chip-based External Cavity Laser (ECL) and an SOA arranged in a first assembly configuration, in accordance with an embodiment of the present disclosure;
FIG. 7 is a diagram that illustrates an integrated device including a gain chip-based ECL and an SOA arranged in a second assembly configuration, in accordance with an embodiment of the present disclosure;
FIG. 8 is a flowchart that illustrates a method for controlling a resultant output power of an emitted amplified light to a configurable level while maintaining a narrow optical linewidth in the emitted amplified light constant, in accordance with an embodiment of the present disclosure; and
FIG. 9 is a flowchart that illustrates an operation of an optical amplifier in the integrated device at a forward bias and a reverse bias, in accordance with an embodiment of the present disclosure.

### DETAILED DESCRIPTION

The present disclosure is best understood with reference to the detailed figures and descriptions set forth herein. Various embodiments are discussed below with reference to the figures. However, those skilled in the art will readily appreciate that the detailed descriptions provided herein with respect to the figures are merely for explanatory purposes as the devices and methods may extend beyond the described embodiments. In one example, the teachings presented and the needs of a particular application may yield multiple alternate and suitable approaches to implement the functionality of any detail described herein. Therefore, any approach may extend beyond the particular implementation choices in the following embodiments that are described and shown.

References to "an embodiment", "another embodiment", "yet another embodiment", "one example", "another example", "yet another example", "for example" and so on, indicate that the embodiment(s) or example(s) so described may include a particular feature, structure, characteristic, property, element, or limitation, but that not every embodiment or example necessarily includes that particular feature, structure, characteristic, property, element, or limitation. Furthermore, repeated use of the phrase "in an embodiment" does not necessarily refer to the same embodiment.

Various embodiments of the disclosure may be found in the disclosed devices and methods for setting, controlling, and stabilizing an output power of light emitted by a narrow linewidth laser source without any impact to a narrow optical linewidth of the emitted light and a lasing wavelength of the narrow linewidth laser source. Various embodiments of the disclosure provide an integrated device for controlling a resultant output power of an emitted amplified light to a configurable level while maintaining the narrow optical linewidth and the lasing wavelength in the emitted amplified light constant.

Narrow linewidth laser sources may refer to laser devices configured to emit light with a minimal range of optical frequencies or wavelengths, resulting in a narrow spectral width also referred to as a "narrow optical linewidth". Optical linewidth may refer to a width (e.g., a full-width at half-maximum "FWHM") of an emission spectrum of a laser source, that is, the width of a range of optical frequencies or wavelengths that the laser source emits. For a narrow linewidth laser source, the optical linewidth is substantially small, resulting in an emission of light at a very specific and well-defined frequency or wavelength. Narrower the optical linewidth, the closer the light is to a single frequency with minimal spread, resulting in highly monochromatic laser light. In an example, a laser source with an optical linewidth of less than 1 megahertz (MHz) may be considered to have a narrow linewidth. A narrow linewidth laser source may, therefore, refer to a single-frequency laser source that produces light with a substantially narrow optical emission spectrum or optical linewidth.

A narrow optical linewidth may imply that the light emitted by the narrow linewidth laser source may be highly coherent, with a long coherence length. A longer coherence length may allow the light to maintain its phase over a greater distance, which may be useful for applications that rely on stable interference patterns. The narrower optical linewidth may therefore enhance the usefulness of narrow linewidth laser sources for applications that require precise wavelength control, high spectral purity, and stability of the emitted light. Narrow linewidth laser sources are useful for various applications including, for example, Frequency-Modulated Continuous-Wave (FMCW) coherent communications, photonic sensing, interferometry, Light Detection and Ranging (LiDAR) systems, or the like. The narrow optical linewidth of the light emitted by these laser sources may provide lower dispersion and higher Signal-to-Noise Ratios (SNRs) in these applications.

A drive current may be utilized to control an optical output power of a narrow linewidth laser source under its operating temperature condition. As used herein, "drive current" may refer to an electric current applied to a laser source to allow the laser source to operate and emit light with a specific output power. The achievable optical linewidth of an optical emission may depend on the design and build of a laser chip; however, the value of this optical linewidth may change when the drive current is varied. In addition to the optical linewidth and the output power, a lasing wavelength of the narrow linewidth laser source may also depend on the drive current. As used herein, "lasing wavelength" may refer to a central wavelength (or frequency) of light that a laser source may emit in its lasing mode and around which an output spectrum of the laser source is concentrated.

In view of the above discussion, when the drive current is varied to control and stabilize the output power of the light emitted by the narrow linewidth laser source, the optical linewidth and the lasing wavelength may also be affected and altered. Typically, the optical linewidth may be large under a low drive current, for example, 150 milliamperes (mA), and a low output power condition, and may reduce to a smaller value with a higher drive current, for example, 300 mA, and a high optical power output. Increasing the drive current and the output power of the narrow linewidth laser source may impact the optical linewidth and the lasing wavelength of the narrow linewidth laser source. The performance of the narrow linewidth laser source must be maintained and must not be affected during control and stabilization of the output power of the narrow linewidth laser source to a specific level in accordance with operating or environmental conditions. Specifically, the optical linewidth should be kept at its narrow state across the required operating conditions. Further, the lasing wavelength of the narrow linewidth laser source must be maintained constant across the required operating conditions.

To set, control, and stabilize the optical output power of the narrow linewidth laser source without any impact to the optical linewidth and the lasing wavelength, the present disclosure may integrate an optical amplifier, for example, a semiconductor optical amplifier, with the narrow linewidth laser source. The integration of the optical amplifier may enable independent control of the optical output power and other performance parameters of the narrow linewidth laser source. By integrating the optical amplifier with the narrow linewidth laser source and operating the integrated optical amplifier such that its optical gain is varied to amplify the output power of the narrow linewidth laser source, the resultant optical output of the integrated device can be kept at a stabilized optical output power level. As used herein, the term "gain" may refer to a factor by which an input light signal, for example, the light received from the narrow linewidth laser source, is amplified. The gain may be measured, for example, as the ratio of output power to input power in decibel (dB). A higher gain results in a higher output optical signal. The integrated device may allow the narrow linewidth laser source to operate at a fixed current to emit a light having a narrow optical linewidth. If the operating conditions are changed and the output power needs to be changed, the integrated device may allow the settings of the narrow linewidth laser source to be left unchanged, while the settings of the optical amplifier may be changed, for example, by varying the drive current applied to the optical amplifier to generate an amplified light having the same narrow optical linewidth and lasing wavelength as those emitted by the narrow linewidth laser source.

In various embodiments, the integrated device disclosed herein may include a laser source and an optical amplifier. In an example, the laser source may refer to a distributed feedback laser. In a further example, the laser source may refer to a gain chip-based external cavity laser. The laser source may be configured to emit a light having a narrow optical linewidth at an initial output power. The narrow optical linewidth may, for example, be in a range from 10 kilohertz (kHz) to 1 MHz. In a further example, the narrow optical linewidth may be any optical linewidth less than 1 MHz. In an embodiment, the optical amplifier may be a semiconductor optical amplifier. The optical amplifier may be operably coupled to the laser source. The optical amplifier may receive the light from the laser source, amplify the received light, and emit the amplified light. The optical amplifier may control a resultant output power of the emitted amplified light to a configurable level while maintaining the narrow optical linewidth in the emitted amplified light constant. In an embodiment, the optical amplifier may maintain a lasing wavelength of the laser source constant during the control of the resultant output power of the emitted amplified light to the configurable level. The lasing wavelength may, for example, be in an O-band, a C-band, or an L-band of an optical spectrum. The O-band may have a central wavelength of 1310 nanometers (nm), the C-band may have a central wavelength of 1550 nm, and the L-band may have a central wavelength of 1600 nm. In an embodiment, the optical amplifier in the integrated device may be selected based on the lasing wavelength of the laser source. For example, if the laser source is configured to generate a lasing wavelength in the O-band of the optical spectrum, the optical amplifier that may operate in the O-band is selected for integration with the laser source to match with the laser source.

In an embodiment, the laser source may include a laser waveguide that extends from a front facet to a rear facet of the laser source. As used herein, "laser waveguide" may refer to a structure configured to confine and direct light within a specific path in a laser cavity of the laser source to ensure optimal propagation and interaction within the laser source. In various embodiments, the laser waveguide is substantially perpendicular to the front facet and the rear facet of the laser source. The laser waveguide may include a rear end and an output end. In an embodiment, the rear end of the laser waveguide may be configured to be perpendicular to the rear facet of the laser source. In various embodiments, the output end of the laser waveguide may be configured to be perpendicular to the front facet of the laser source. In several embodiments, the output end of the laser waveguide may be configured to be angled with respect to the front facet of the laser source.

In various embodiments, the output end of the laser waveguide may be a straight active waveguide. As used herein, "straight active waveguide" may refer to a linear optical waveguide that may transmit and guide light within the laser source, and include an optically active material or active components that can change properties of the light or modulate the light. In various embodiments, the output end of the laser waveguide may be a passive angled waveguide. As used herein, "passive angled waveguide" may refer to a type of optical waveguide configured to guide light within the laser source while utilizing an angled interface to manage light propagation and coupling. The passive angled waveguide may not actively amplify or modulate the light, but may merely guide the light. Further, the passive angled waveguide may feature an angled facet or end face that affects how the light may be coupled in and out of the waveguide or interact with other optical components. In further embodiments, the passive angled waveguide may be configured as a spot-size converter that aligns with an optical mode of the optical amplifier.

In an embodiment, the optical amplifier may include an amplifier waveguide that extends from an input facet to an output facet of the optical amplifier. As used herein, "amplifier waveguide" may refer to a structure configured to confine and direct the light received from the narrow linewidth laser source within a specific path in the optical amplifier to ensure optimal propagation and interaction within the optical amplifier. In various embodiments, the amplifier waveguide may be substantially perpendicular to the input facet and the output facet of the optical amplifier. The amplifier waveguide may include an input end and an output end. The input end of the amplifier waveguide may refer to an input waveguide portion of the amplifier waveguide. The output end of the amplifier waveguide may refer to an output waveguide portion of the amplifier waveguide. In an embodiment, the input end of the amplifier waveguide may be configured to be perpendicular to the input facet of the optical amplifier. In various embodiments, the input end of the amplifier waveguide may be configured to be angled with respect to the input facet of the optical amplifier. In various embodiments, the input end of the amplifier waveguide may be a straight waveguide. In various embodiments, the input end of the amplifier waveguide may be an angled waveguide. In various embodiments, the output end of the amplifier waveguide may be configured to be angled with respect to the output facet of the optical amplifier. In additional embodiments, the integrated device may include an anti-reflection coating on the input end at the input facet of the optical amplifier and on the output end at the output facet of the optical amplifier. The output end of the laser waveguide may be optically coupled to the input end of the amplifier waveguide.

In various embodiments, the optical amplifier may be oriented with respect to the laser source such that an optical axis of the laser source is aligned with an input optical axis of the optical amplifier. The input optical axis of the optical amplifier may refer to an optical axis of the input end (or the input waveguide portion) of the amplifier waveguide. In an embodiment, the optical axis of the laser source may be collinear with the input optical axis of the optical amplifier.

In an embodiment, the integrated device may further include at least one controller operably coupled to the laser source. The controller may be configured to control an applied drive current that maintains the initial output power of the light. In various embodiments, the integrated device may further include at least one controller operably coupled to the optical amplifier. The controller may be configured to vary an optical gain of the optical amplifier to amplify the initial output power of the light from the laser source and stabilize the resultant output power to the configurable level. In several embodiments, the optical amplifier may be further configured to adjust an optical power drift from the initial output power of the light from the laser source during the control of the resultant output power of the emitted amplified light to the configurable level.

In an embodiment, the optical amplifier of the integrated device may be configured to operate with a reverse bias and a forward bias. In various embodiments, based on operation with the forward bias, the optical amplifier may receive the light from the laser source, amplify the received light, emit the amplified light, and control a resultant output power of the emitted amplified light to a configurable level while maintaining the narrow optical linewidth in the emitted amplified light constant. In various embodiments, based on operation with the reverse bias, the optical amplifier may operate as an optical absorber, and suppress the received light having the narrow optical linewidth without requiring a change to a drive current of the laser source.

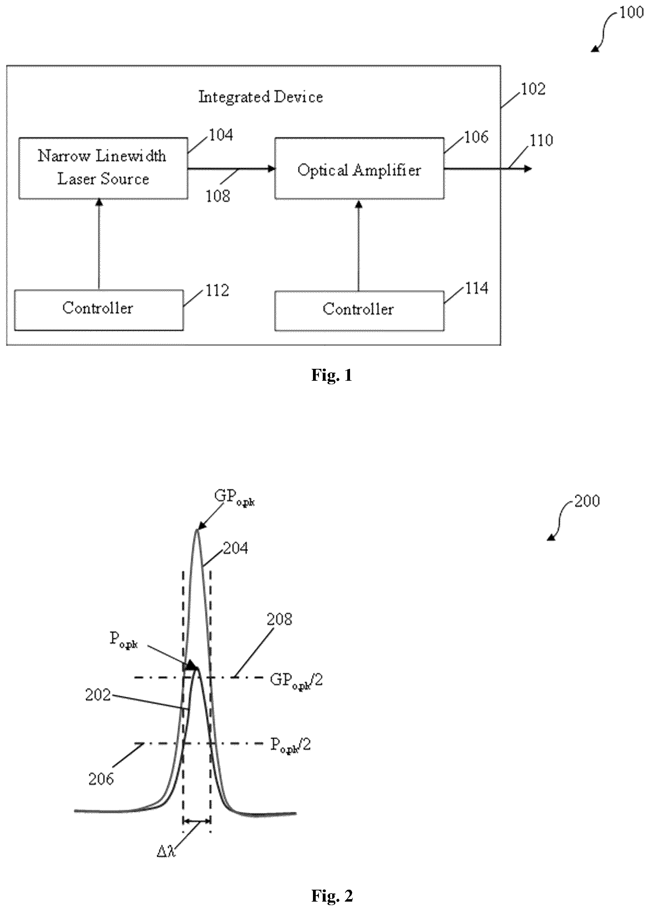

Referring now to FIG. 1, a diagram 100 that illustrates an integrated device 102 for optical power control and stabilization, in accordance with an embodiment of the present disclosure, is shown. The integrated device 102 disclosed herein may include a narrow linewidth laser source 104 configured to emit a light 108 having a narrow optical linewidth at an initial output power. In an example, the narrow linewidth laser source 104 may be a Distributed FeedBack (DFB) laser operating in the infrared wavelength region of an electromagnetic spectrum. The DFB laser may refer to a laser device whose active medium may include a repeating corrugated structure. The corrugated structure may be a periodic variation of a refractive index and thus acts as a diffraction grating, which provides optical feedback throughout the corrugated structure. As a result, the DFB laser may emit only a single wavelength, thereby being able to produce a substantially narrow optical linewidth output. The DFB laser may emit a light 108 having a narrow optical linewidth of, for example, 1 kilohertz (kHz) to 1 megahertz (MHz), and an output power of some tens of milliwatts (mW) or above 100 mW. In a further example, the narrow linewidth laser source 104 may be a gain chip-based External Cavity Laser (ECL). The gain chip-based ECL may operate in a range of wavelengths based on a gain medium and design of the ECL. The light 108 emitted by the narrow linewidth laser source 104 may be, for example, a continuous wave, pulsed, or modulated in any suitable manner for a given application.

The integrated device 102 may further include an optical amplifier 106. FIG. 1 illustrates the integration of the narrow linewidth laser source 104 with the optical amplifier 106. In an embodiment, the optical amplifier 106 may be a Semiconductor Optical Amplifier (SOA). The SOA may refer to a device that amplifies light through stimulated emission by utilizing a semiconductor material as a gain medium. For purposes of illustration, the disclosure herein refers to the optical amplifier 106 being an SOA; however, the scope of the disclosure herein is not limited to the optical amplifier 106 being an SOA, but extends to include any optical amplifier configured to set, control, and stabilize an output power of a light 110 emitted by the integrated device 102 without any impact to the narrow optical linewidth of the emitted light 108 and a lasing wavelength of the narrow linewidth laser source 104.

The optical amplifier 106 (interchangeably referred to as the "SOA 106"), is operably coupled to the narrow linewidth laser source 104. In an embodiment, an output port of the narrow linewidth laser source 104 may be operably coupled to an input port of the SOA 106 to allow the SOA 106 to receive the light 108 having a narrow optical linewidth at an initial output power from the output port of the narrow linewidth laser source 104. In various embodiments, to couple the narrow linewidth laser source 104 to the SOA 106, mode field diameters of the narrow linewidth laser source 104 and the SOA 106 may be aligned to minimize losses. This alignment may require optical modes of the laser output and the SOA input to be compatible, which may require lenses or optical fibers to properly couple the light 108. In various embodiments, the output port of the narrow linewidth laser source 104 may be coupled to the input port of the SOA 106 via optical fibers by utilizing, for example, a fiber-to-fiber coupling technique, a fiber-to-facet coupling technique, or the like. The SOA 106 may operate at signal wavelengths between, for example, 850 nanometers (nm) and 1600 nm and may generate gains of up to 30 decibels (dB). In an embodiment, the gain profile of the SOA 106 may be broader than the narrow optical linewidth of the light 108 emitted by the narrow linewidth laser source 104. In various embodiments, the gain of the SOA 106 may be configured to be constant across an operating wavelength range, thereby allowing uniform amplification of the received light 108, regardless of wavelength, and maintaining the narrow optical linewidth of the amplified light 110 constant.

The SOA 106 may receive the light 108 from the narrow linewidth laser source 104 and amplify the received light 108. The received light 108 may travel through a narrow path in the semiconductor material of the SOA 106. When the SOA 106 receives the light 108 from the narrow linewidth laser source 104, the received light 108 may interact with excited electrons within an active gain layer comprising a bulk layer, quantum wells, quantum wires, or quantum dots, of the semiconductor material. Through the process of stimulated emission, these electrons may lose energy and emit photons of the same wavelength as the received light 108, creating a population inversion that may generate gain within the semiconductor material. This gain may amplify the received light 108 as the received light 108 travels through the SOA 106. Consequently, the amplified light 110 may emerge from the SOA 106, maintaining the wavelength of the received light 108. In the SOA 106, electrical carriers may be injected by a drive current, to allow an optical power of the received light 108 to be increased, and basic physical properties such as polarization, the narrow optical linewidth, and frequency of the received light 108 to be maintained. With the increase of the drive current, the optical output power may also increase based on a certain function.

After amplification, the SOA 106 may emit the amplified light 110 through an output port of the SOA 106. The SOA 106 may control a resultant output power of the emitted amplified light 110 to a configurable level while maintaining the narrow optical linewidth in the emitted amplified light 110 constant. In an embodiment, the SOA 106 may maintain a lasing wavelength of the narrow linewidth laser source 104 constant during the control of the resultant output power of the emitted amplified light 110 to the configurable level. That is, the emitted amplified light 110 may have the same narrow optical linewidth and lasing wavelength as the light 108 emitted by the narrow linewidth laser source 104. In various embodiments, the narrow linewidth laser source 104 may be driven to operate at settings of temperature and current whereby performance parameters of the narrow optical linewidth and the lasing wavelength are met. Several design considerations including, for example, active waveguide design and device length, are implemented for realizing the narrow optical linewidth in the narrow linewidth laser source 104. For example, a longer narrow linewidth laser source 104 may emit a light 108 having a narrower optical linewidth. The targeted narrow optical linewidth may be achieved over a particular operating current of the narrow linewidth laser source 104. Any fine-tuning of the resultant output power of the emitted amplified light 110 can be realized by driving the SOA 106 to achieve the required optical gain for the desired output power under continuous monitoring. The resultant output power of the integrated device 102 may be fine-tuned by varying the drive current of the SOA 106, which in turn, may vary the optical gain of the SOA 106. In this manner, the narrow optical linewidth and the lasing wavelength may remain unchanged while the optical output power is varied according to requirements. In further embodiments, the SOA 106 may also serve to even out any optical power drift or variation from the narrow linewidth laser source 104 to achieve a stabilized optical output. By varying the drive current of the SOA 106 to tune its optical gain, any power drift from the narrow linewidth laser source 104 can be compensated and any power variation evened out.

In an embodiment, the integrated device 102 may further include at least one controller 112 operably coupled to the narrow linewidth laser source 104. The controller 112 may be configured to control an applied drive current that maintains the initial output power of the light 108. In various embodiments, the controller 112 may utilize a feedback loop to compare a measured output power with a predefined setpoint, that is, a desired output power. The difference between the actual output power and the desired output power may be utilized to adjust the drive current that may be applied to the narrow linewidth laser source 104. In various embodiments, the integrated device 102 may further include at least one controller 114 operably coupled to the SOA 106. The controller 114 may be configured to vary an optical gain of the SOA 106 to amplify the initial output power of the light 108 from the narrow linewidth laser source 104 and stabilize the resultant output power of the emitted amplified light 110 to the configurable level.

The output power of the narrow linewidth laser source 104 is controlled by its operating current and laser chip temperature. The SOA 106 may then be operated such that its gain spectrum may overlap with an emission spectrum of the narrow linewidth laser source 104, and such that the drive current of the SOA 106 may be set to achieve the optical gain required to obtain the resultant output power of the integrated device 102. In further embodiments, the SOA 106 may be configured to adjust an optical power drift from the initial output power of the light 108 from the narrow linewidth laser source 104 during the control of the resultant output power of the emitted amplified light 110 to the configurable level. In several embodiments, the integrated device 102 including the narrow linewidth laser source 104 and the SOA 106 may be fabricated by conventional fabrication processes of epitaxial layer growth, waveguide formation, contact metallizations, bar cleaving, optical coating deposition, and final die cleaving. In various embodiments, the integrated device 102 including the narrow linewidth laser source 104 and the SOA 106 may be mounted on any heat dissipation substrate made, for example, of aluminum nitride, silicon carbide, or the like.

For the sake of brevity, the ongoing description is described with respect to an SOA 106 integrated with a DFB laser or a gain chip-based ECL. However, in various embodiments, the integrated device 102 may operate in a similar manner with other optical amplifiers integrated with other types of narrow linewidth laser sources to execute similar or different functionalities.

FIG. 2 is a graphical representation 200 that illustrates a spectral distribution of a narrow linewidth laser source 104 and an amplified spectrum thereof, in accordance with an embodiment of the present disclosure. The graphical representation 200 is described in conjunction with FIG. 1. The spectral distribution may be represented with wavelength on a horizontal axis and output power on a vertical axis. The graphical representation 200 in FIG. 2 illustrates a spectral profile 202 of the narrow linewidth laser source 104, for example, a DFB laser, whereby optical power density Pₒ(λ) increases to its peak value (referred to as a lasing wavelength), before falling off to a power baseline. The graphical representation 200 in FIG. 2 also illustrates an output spectral profile 204 of the SOA 106, showing amplification of the light 108 received from the narrow linewidth laser source 104. The optical linewidth Δλ may refer to a wavelength separation between two points where the optical power density is half of its peak power density value as represented by lines 206 and 208 in FIG. 2. After the emitted light 108 received from the narrow linewidth laser source 104 propagates through the SOA 106, the optical power may increase to GPₒ(λ), where G is the optical gain or amplification factor. The SOA 106 may control a resultant output power of the emitted amplified light 110 to a configurable level while maintaining the narrow optical linewidth Δλ in the emitted amplified light 110 constant. As illustrated in FIG. 2, while the resultant output power of the emitted amplified light 110 is higher than the initial output power of the light 108 received from the narrow linewidth laser source 104, the narrow optical linewidth of the emitted amplified light 110 remains unchanged. That is, the integrated device 102 disclosed herein maintains the narrow optical linewidth of the light 108 emitted from the narrow linewidth laser source 104 and the narrow optical linewidth in the amplified light 110 emitted from the SOA 106 constant.

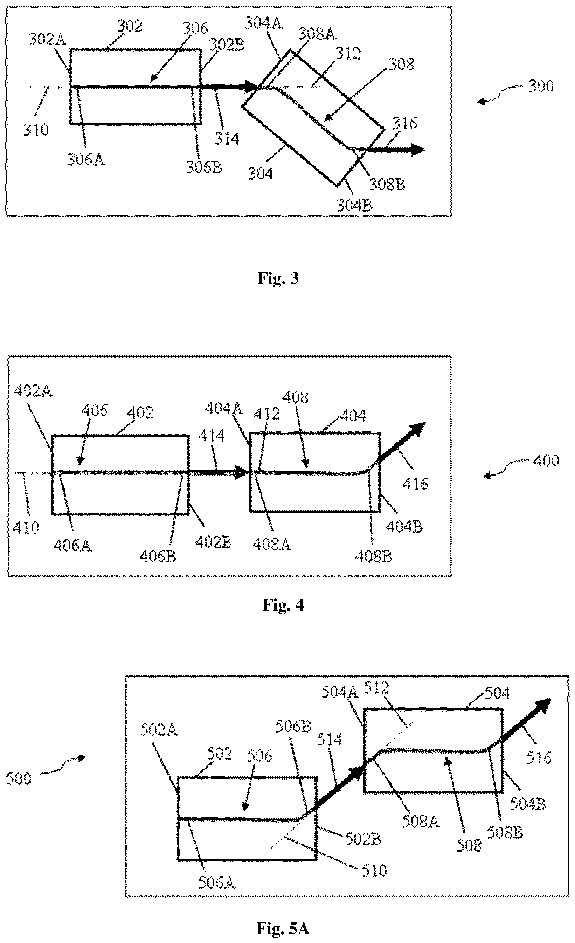

FIG. 3 is a diagram that illustrates an integrated device 300 including a Distributed FeedBack (DFB) laser 302 and an SOA 304 arranged in a first assembly configuration, in accordance with an embodiment of the present disclosure. The DFB laser 302 may operate as a narrow linewidth laser source configured to emit a light 314 having a narrow optical linewidth at an initial output power. The DFB laser 302 may include a rear facet 302A, a front facet 302B, and a laser waveguide 306 that extends from the rear facet 302A to the front facet 302B. In an embodiment, the laser waveguide 306 is substantially perpendicular to the rear facet 302A and the front facet 302B of the DFB laser 302. The laser waveguide 306 may include a rear end 306A and an output end 306B. In an embodiment, the rear end 306A of the laser waveguide 306 may be perpendicular to the rear facet 302A of the DFB laser 302 as illustrated in FIG. 3. In a further embodiment, the output end 306B of the laser waveguide 306 may be perpendicular to the front facet 302B of the DFB laser 302 as illustrated in FIG. 3. In various embodiments, the output end 306B of the laser waveguide 306 may be a straight active waveguide.

Further, the SOA 304 may include an input facet 304A, an output facet 304B, and an amplifier waveguide 308 that extends from the input facet 304A to the output facet 304B. In an embodiment, the amplifier waveguide 308 is substantially perpendicular to the input facet 304A and the output facet 304B of the SOA 304. The amplifier waveguide 308 may include an input end 308A and an output end 308B. The input end 308A of the amplifier waveguide 308 may refer to an input waveguide portion of the amplifier waveguide 308. The output end 308B of the amplifier waveguide 308 may refer to an output waveguide portion of the amplifier waveguide 308. In various embodiments, the input end 308A of the amplifier waveguide 308 may be angled with respect to the input facet 304A of the SOA 304 as illustrated in FIG. 3. In such embodiments, the input end 308A of the amplifier waveguide 308 may be an angled waveguide. In a further embodiment, the output end 308B of the amplifier waveguide 308 may be angled with respect to the output facet 304B of the SOA 304 as illustrated in FIG. 3. As such, in the first assembly configuration, the laser waveguide 306 of the DFB laser 302 may be straight and normal to the rear facet 302A and the front facet 302B, while the SOA 304 may include an angled waveguide at its two facets, that is, the input facet 304A and the output facet 304B.

In the first assembly configuration, the output end 306B from the straight laser waveguide 306 of the DFB laser 302 may be optically coupled into the angled input end 308A of the amplifier waveguide 308 of the SOA 304. In an embodiment, the two chips, that is, the DFB laser 302 and the SOA 304 may be butt-coupled in close proximity to each other. In various embodiments, the DFB laser 302 and the SOA 304 may be lens-coupled in close proximity to each other. In an example, microlenses may be utilized for optically coupling the output end 306B of the laser waveguide 306 of the DFB laser 302 into the input end 308A of the amplifier waveguide 308 of the SOA 304. In various embodiments as illustrated in FIG. 3, the SOA 304 may be oriented with respect to the DFB laser 302 such that an optical axis 310 of the DFB laser 302 may be aligned with an input optical axis 312 of the SOA 304. The input optical axis 312 of the SOA 304 may refer to an optical axis of the input end 308A (or the input waveguide portion) of the amplifier waveguide 308. In such embodiments, the optical axis 310 of the DFB laser 302 may be collinear with the input optical axis 312 of the SOA 304. For example, due to the angled input end 308A of the amplifier waveguide 308, the SOA 304 may be tilted such that the input optical axis 312 of the SOA 304 matches with the optical axis 310 of the DFB laser 302. In various embodiments, the angle of the input end 308A of the amplifier waveguide 308 may be configured to be small so that a tilt angle between the DFB laser 302 and the SOA 304 may also be small to realize low loss optical coupling. Low loss optical coupling may refer to techniques and methods for coupling the DFB laser 302 to the SOA 304 with minimal loss of optical power to allow transfer of the light 314 from the DFB laser 302 to the SOA 304 with high efficiency ensuring that a substantial portion of the light 314 may be preserved during the coupling process. In an embodiment, one of the design considerations to realize low loss optical coupling may be to match an exit direction of the output from the DFB laser 302 to an optical input direction of the SOA 304.

In various embodiments, the DFB laser 302 may include a laser gain medium layer and a guiding layer which are sandwiched between p-type and n-type semiconductors. The guiding layer may include a corrugated structure responsible for providing distributed optical feedback. The p-type and n-type layers may have a metal deposition at their outer surfaces to enable an electrical current input which supplies a pumping energy and hence supports lasing action in the DFB laser 302. The DFB laser 302 may emit the light 314 having a narrow optical linewidth at an initial output power. The SOA 304 may receive, at the input facet 304A, the light 314 emitted by the DFB laser 302, amplify the received light 314 as the received light 314 propagates along the amplifier waveguide 308 of the SOA 304 from the input facet 304A to the output facet 304B, and emit, from the output facet 304B, an amplified light 316. The SOA 304 may control a resultant output power of the emitted amplified light 316 to a configurable level while maintaining the narrow optical linewidth in the emitted amplified light 316 constant. The SOA 304 may also maintain a lasing wavelength of the DFB laser 302 constant during the control of the resultant output power of the emitted amplified light 316 to the configurable level. That is, the emitted amplified light 316 may have the same narrow optical linewidth and lasing wavelength as the light 314 emitted by the DFB laser 302.

FIG. 4 is a diagram that illustrates an integrated device 400 including a DFB laser 402 and an SOA 404 arranged in a second assembly configuration, in accordance with an embodiment of the present disclosure. The DFB laser 402 may operate as a narrow linewidth laser source configured to emit a light 414 having a narrow optical linewidth at an initial output power. The DFB laser 402 may include a rear facet 402A, a front facet 402B, and a laser waveguide 406 that extends from the rear facet 402A to the front facet 402B. In an embodiment, the laser waveguide 406 is substantially perpendicular to the rear facet 402A and the front facet 402B of the DFB laser 402. The laser waveguide 406 may include a rear end 406A and an output end 406B. In an embodiment, the rear end 406A of the laser waveguide 406 may be perpendicular to the rear facet 402A of the DFB laser 402 as illustrated in FIG. 4. In a further embodiment, the output end 406B of the laser waveguide 406 may be perpendicular to the front facet 402B of the DFB laser 402 as illustrated in FIG. 4. In various embodiments, the output end 406B of the laser waveguide 406 may be a straight active waveguide.

Further, the SOA 404 may include an input facet 404A, an output facet 404B, and an amplifier waveguide 408 that extends from the input facet 404A to the output facet 404B. In an embodiment, the amplifier waveguide 408 is substantially perpendicular to the input facet 404A and the output facet 404B of the SOA 404. The amplifier waveguide 408 may include an input end 408A and an output end 408B. The input end 408A of the amplifier waveguide 408 may refer to an input waveguide portion of the amplifier waveguide 408. The output end 408B of the amplifier waveguide 408 may refer to an output waveguide portion of the amplifier waveguide 408. In various embodiments, the input end 408A of the amplifier waveguide 408 may be perpendicular to the input facet 404A of the SOA 404 as illustrated in FIG. 4. In such embodiments, the input end 408A of the amplifier waveguide 408 may be a straight waveguide. In a further embodiment, the output end 408B of the amplifier waveguide 408 may be angled with respect to the output facet 404B of the SOA 404 as illustrated in FIG. 4. As such, in the second assembly configuration, the laser waveguide 406 of the DFB laser 402 may be straight and normal to its facets, that is, the rear facet 402A and the front facet 402B, while the SOA 404 may include a straight waveguide at its input facet 404A and an angled waveguide at its output facet 404B.

In the second assembly configuration, the output end 406B from the straight laser waveguide 406 of the DFB laser 402 may be optically coupled into the straight input end 408A of the amplifier waveguide 408 of the SOA 404. In an embodiment, the two chips, that is, the DFB laser 402 and the SOA 404 may be butt-coupled in close proximity to each other. In various embodiments, the DFB laser 402 and the SOA 404 may be lens-coupled in close proximity to each other. In an example, microlenses may be utilized for optically coupling the output end 406B of the laser waveguide 406 of the DFB laser 402 into the input end 408A of the amplifier waveguide 408 of the SOA 404. In various embodiments as illustrated in FIG. 4, the SOA 404 may be oriented with respect to the DFB laser 402 such that an optical axis 410 of the DFB laser 402 may be aligned with an input optical axis 412 of the SOA 404. The input optical axis 412 of the SOA 404 may refer to an optical axis of the input end 408A (or the input waveguide portion) of the amplifier waveguide 408. In such embodiments, the optical axis 410 of the DFB laser 402 may be collinear with the input optical axis 412 of the SOA 404. In the second assembly configuration, the input end 408A of the amplifier waveguide 408 of the SOA 404 may be modified to be straight to allow the input end 408A to receive the incoming light 414 from the DFB laser 402 without any requirement of tilt of the SOA 404.

In an embodiment, an anti-reflection coating (not shown) is applied on the input end 408A at the input facet 404A and on the output end 408B at the output facet 404B of the SOA 404 for all configurations of the SOA 404. As the input end 408A of the amplifier waveguide 408 of the SOA 404 may be straight and normal to the input facet 404A of the SOA 404, the anti-reflection coating applied to this straight input facet 404A must have a substantially low reflectivity of, for example, much less than 10⁻⁴, to substantially suppress any back-reflection from this input facet 404A. In the second assembly configuration illustrated in FIG. 4, the anti-reflection coating on the straight input facet 404A of the SOA 404 may be enhanced with a substantially low reflectivity to minimize back-reflection from this straight input facet 404A without affecting the performance of the SOA 404. Further, in an embodiment, one of the design considerations to realize low loss optical coupling between the DFB laser 402 and the SOA 404 may be to ensure the smallest separation between the chips of the DFB laser 402 and the SOA 404, when the front facet 402B and the input facet 404A of the DFB laser 402 and the SOA 404, respectively, are parallel to each other as illustrated in FIG. 4.

In various embodiments, the DFB laser 402 may include a laser gain medium layer and a guiding layer as disclosed in the description of FIG. 3. The DFB laser 402 may emit a light 414 having a narrow optical linewidth at an initial output power. The SOA 404 may receive, at the input facet 404A, the light 414 emitted by the DFB laser 402, amplify the received light 414 as the received light 414 propagates along the amplifier waveguide 408 of the SOA 404 from the input facet 404A to the output facet 404B, and emit, from the output facet 404B, an amplified light 416. The SOA 404 may control a resultant output power of the emitted amplified light 416 to a configurable level while maintaining the narrow optical linewidth in the emitted amplified light 416 constant. The SOA 404 may also maintain a lasing wavelength of the DFB laser 402 constant during the control of the resultant output power of the emitted amplified light 416 to the configurable level. That is, the emitted amplified light 416 may have the same narrow optical linewidth and lasing wavelength as the light 414 emitted by the DFB laser 402.

FIG. 5A is a diagram that illustrates an integrated device 500 including a DFB laser 502 and an SOA 504 arranged in a third assembly configuration, in accordance with an embodiment of the present disclosure. The DFB laser 502 may operate as a narrow linewidth laser source configured to emit a light 514 having a narrow optical linewidth at an initial output power. The DFB laser 502 may include a rear facet 502A, a front facet 502B, and a laser waveguide 506 that extends from the rear facet 502A to the front facet 502B. In an embodiment, the laser waveguide 506 is substantially perpendicular to the rear facet 502A and the front facet 502B of the DFB laser 502. In a further embodiment, the front facet 502B of the DFB laser 502 may be an optically transparent, angled facet. The laser waveguide 506 may include a rear end 506A and an output end 506B. The rear end 506A of the laser waveguide 506 may refer to a rear waveguide portion of the laser waveguide 506. The output end 506B of the laser waveguide 506 may refer to an output waveguide portion of the laser waveguide 506. In an embodiment, the rear end 506A of the laser waveguide 506 may be perpendicular to the rear facet 502A of the DFB laser 502 as illustrated in FIG. 5A. In a further embodiment, the output end 506B of the laser waveguide 506 may be angled with respect to the front facet 502B of the DFB laser 502 as illustrated in FIG. 5A. In a further embodiment, the output end 506B (or the output waveguide portion) of the laser waveguide 506 may be an optically transparent, angled waveguide.

In various embodiments, the output end 506B of the laser waveguide 506 may be a passive angled waveguide. In other words, the DFB laser 502 may be configured with a passive angled waveguide that matches with an angled input of the SOA 504. In an embodiment, the passive angled waveguide of the DFB laser 502 may be configured as a spot-size converter to better match with an optical mode of the SOA 504. As a spot-size converter, the passive angled waveguide may be configured to adjust the size of an output beam of the light 514 emitted by the DFB laser 502 to align with the optical mode of the SOA 504. In this embodiment, the SOA 504 does not have to be tilted as the passive angled waveguide of the DFB laser 502 matches with the angled input of the SOA 504. Hence, the two chips, that is, the DFB laser 502 and the SOA 504, may be disposed in very close proximity to each other, minimizing the coupling loss between the two chips. In an embodiment, one of the design considerations to realize low loss optical coupling between the DFB laser 502 and the SOA 504 may be to ensure the smallest separation between the chips of the DFB laser 502 and the SOA 504, when the front facet 502B and an input facet 504A of the DFB laser 502 and the SOA 504, respectively, are parallel to each other as illustrated in FIG. 5A. Further, besides minimizing the tilt requirement between the DFB laser 502 and the SOA 504, in an embodiment, an index-matching gel can be inserted into a gap between the two chips to further reduce reflection and improve optical coupling between the two chips.

Further, the SOA 504 may include the input facet 504A, an output facet 504B, and an amplifier waveguide 508 that extends from the input facet 504A to the output facet 504B. In an embodiment, the amplifier waveguide 508 is substantially perpendicular to the input facet 504A and the output facet 504B of the SOA 504. The amplifier waveguide 508 may include an input end 508A and an output end 508B. The input end 508A of the amplifier waveguide 508 may refer to an input waveguide portion of the amplifier waveguide 508. The output end 508B of the amplifier waveguide 508 may refer to an output waveguide portion of the amplifier waveguide 508. In various embodiments, the input end 508A of the amplifier waveguide 508 may be angled with respect to the input facet 504A of the SOA 504 as illustrated in FIG. 5A. In such embodiments, the input end 508A of the amplifier waveguide 508 may be an angled waveguide. In a further embodiment, the output end 508B of the amplifier waveguide 508 may be angled with respect to the output facet 504B of the SOA 504 as illustrated in FIG. 5A. As such, in the third assembly configuration, the laser waveguide 506 of the DFB laser 502 may be straight and normal at the rear facet 502A and angled at the front facet 502B, while the SOA 504 may include an angled waveguide at its two facets, that is, the input facet 504A and the output facet 504B.

In various embodiments as illustrated in FIG. 5A, the SOA 504 may be oriented with respect to the DFB laser 502 such that an output optical axis 510 of the DFB laser 502 may be aligned with an input optical axis 512 of the SOA 504. The output optical axis 510 of the DFB laser 502 may refer to an optical axis of the output end 506B (or the output waveguide portion) of the laser waveguide 506. The input optical axis 512 of the SOA 504 may refer to an optical axis of the input end 508A (or the input waveguide portion) of the amplifier waveguide 508. In such embodiments, the output optical axis 510 of the DFB laser 502 may be collinear with the input optical axis 512 of the SOA 504. In the third assembly configuration, the angled output end 506B of the laser waveguide 506 of the DFB laser 502 may be optically coupled into the angled input end 508A of the amplifier waveguide 508 of the SOA 504. Further, as a spot-size converter, the passive angled waveguide at the output end 506B of the laser waveguide 506 may allow optical coupling of the light 514 between the output end 506B of the laser waveguide 506 and the input end 508A of the amplifier waveguide 508.

In various embodiments, the DFB laser 502 may include a laser gain medium layer and a guiding layer as disclosed in the description of FIG. 3. The DFB laser 502 may emit a light 514 having a narrow optical linewidth at an initial output power. The SOA 504 may receive, at the input facet 504A, the light 514 emitted by the DFB laser 502, amplify the received light 514 as the received light 514 propagates along the amplifier waveguide 508 of the SOA 504 from the input facet 504A to the output facet 504B, and emit, from the output facet 504B, an amplified light 516. The SOA 504 may control a resultant output power of the emitted amplified light 516 to a configurable level while maintaining the narrow optical linewidth in the emitted amplified light 516 constant. The SOA 504 may also maintain a lasing wavelength of the DFB laser 502 constant during the control of the resultant output power of the emitted amplified light 516 to the configurable level. That is, the emitted amplified light 516 may have the same narrow optical linewidth and lasing wavelength as the light 514 emitted by the DFB laser 502.

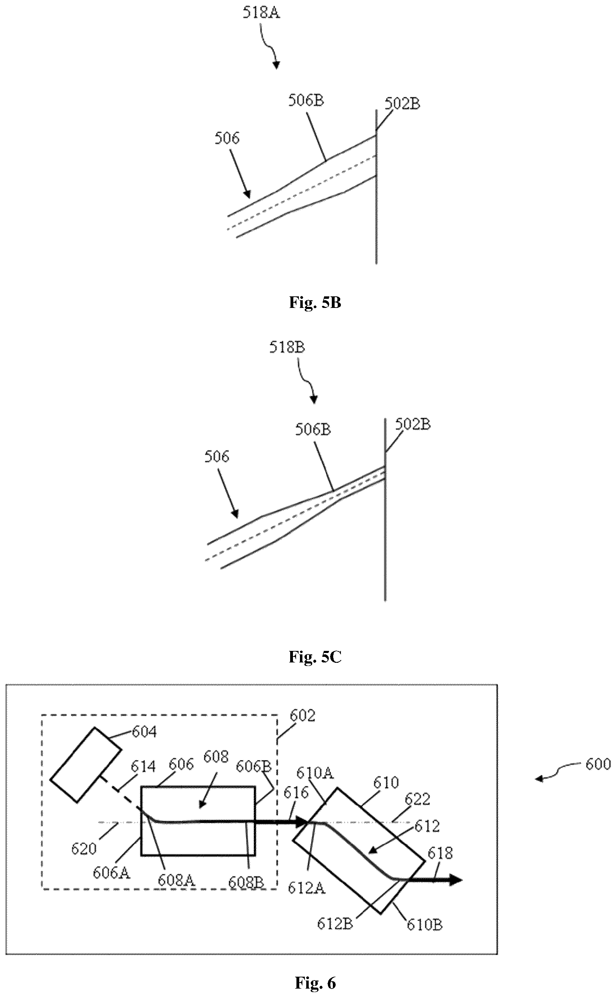

FIGS. 5B and 5C are diagrams that illustrate configurations 518A and 518B of a passive angled waveguide of the DFB laser 502 in the integrated device 500 shown in FIG. 5A, for spot-size conversion. The passive angled waveguide of the DFB laser 502 may be formed at an emission end, that is, the output end 506B of the laser waveguide 506 of the DFB laser 502. In an embodiment, the output end 506B of the laser waveguide 506 may be configured as a taper-out waveguide structure as illustrated in FIG. 5B for spot-size conversion. The taper-out waveguide structure may gradually transition from a smaller cross-sectional area to a larger cross-sectional area at the output end 506B of the laser waveguide 506. This gradual expansion may assist in minimizing reflections and signal loss that can occur during changes in waveguide dimensions. The output end 506B of the laser waveguide 506 may taper out at the front facet 502B of the DFB laser 502 as illustrated in FIG. 5B. In various embodiments, the output end 506B of the laser waveguide 506 may be configured as a taper-in waveguide structure as illustrated in FIG. 5C for spot-size conversion. The taper-in waveguide structure may gradually transition from a larger cross-sectional area to a smaller cross-sectional area at the output end 506B of the laser waveguide 506. This gradual transition may assist in minimizing reflections and signal loss that can occur during changes in waveguide dimensions. The output end 506B of the laser waveguide 506 may taper into the front facet 502B of the DFB laser 502 as illustrated in FIG. 5C. The taper-out and taper-in waveguide structures may be configured to have their far-field divergence matching with a far-field divergence of the input end 508A of the amplifier waveguide 508 of the SOA 504.

FIG. 6 is a diagram that illustrates an integrated device 600 including a gain chip-based External Cavity Laser (ECL) 602 and an SOA 610 arranged in a first assembly configuration, in accordance with an embodiment of the present disclosure. The gain chip-based ECL 602 may refer to a type of laser where the gain medium is a separate, often discrete, gain chip 606 that is utilized in conjunction with an external optical cavity to produce a stable and tunable laser output. The gain chip 606 may refer to a semiconductor device that provides an optical gain needed to amplify light. In an embodiment, the gain chip 606 may include a diode laser or a similar structure that can be electrically pumped to produce coherent light. The gain chip 606 may generate an initial optical signal that may be subsequently amplified within the external optical cavity. The external optical cavity that surrounds the gain chip 606 may be utilized for providing feedback and controlling output characteristics of the gain chip-based ECL 602. The external optical cavity may include one or more reflectors, lenses, or diffraction gratings. In an embodiment as illustrated in FIG. 6, the gain chip-based ECL 602 may include a reflector 604, for example, a mirror, another silicon photonics chip, a fiber Bragg grating, or the like, in the external optical cavity. The external optical cavity may define an emission wavelength of the gain chip-based ECL 602 and assist in stabilizing and narrowing the optical linewidth of the laser output. The external optical cavity may further provide feedback to the gain chip 606 and can be adjusted to tune the laser output.

The gain chip-based ECL 602 may operate as a narrow linewidth laser source configured to emit a light 616 having a narrow optical linewidth at an initial output power. The gain chip 606 of the gain chip-based ECL 602 may include a rear facet 606A, a front facet 606B, and a laser waveguide 608 that extends from the rear facet 606A to the front facet 606B. In an embodiment, the laser waveguide 608 is substantially perpendicular to the rear facet 606A and the front facet 606B of the gain chip 606. The laser waveguide 608 may include a rear end 608A and an output end 608B. In an embodiment, the rear end 608A of the laser waveguide 608 may be angled with respect to the rear facet 606A of the gain chip 606 as illustrated in FIG. 6. In such an embodiment, the rear end 608A of the laser waveguide 608 may be an angled waveguide. In a further embodiment, the output end 608B of the laser waveguide 608 may be perpendicular to the front facet 606B of the gain chip 606 as illustrated in FIG. 6. In such an embodiment, the output end 608B of the laser waveguide 608 may be a straight active waveguide.

The gain chip 606 of the gain chip-based ECL 602 may be integrated with the SOA 610 as illustrated in FIG. 6. In an embodiment, the gain chip 606 may be based on facet reflectivities of anti-reflection on the angled rear facet 606A and low-reflection on the normal front facet 606B. The laser waveguide 608 of the gain chip 606 may include an angled rear end 608A that extends at the rear facet 606A applied with an anti-reflection coating and a normal output end 608B that extends at the front facet 606B applied with a low reflection coating. The gain chip-based ECL 602 is formed between: (a) the reflector 604 that is coupled to the angled rear end 608A of the laser waveguide 608 at the rear facet 606A with the anti-reflection coating; and (b) the normal output end 608B of the laser waveguide 608 at the front facet 606B with the low reflection coating. The reflectivity of the anti-reflection rear facet 606A may be less than 10⁻⁴, while the reflectivity of the low reflection front facet 606B may be in the range of several % to tens of %, depending on the design of the gain chip-based ECL 602. The reflectivity of the reflector 604 and anti-reflection and low reflection facet reflectivities of the gain chip 606 may determine an optical output power of the gain chip-based ECL 602. In a further embodiment, the gain chip-based ECL 602 is formed by coupling a light output 614 from the anti-reflection angled rear facet 606A of the gain chip 606 to the reflector 604. The light 616 may then emit from the low-reflection normal front facet 606B of the gain chip 606 for coupling into the SOA 610.

Further, the SOA 610 may include an input facet 610A, an output facet 610B, and an amplifier waveguide 612 that extends from the input facet 610A to the output facet 610B. In an embodiment, the amplifier waveguide 612 is substantially perpendicular to the input facet 610A and the output facet 610B of the SOA 610. The amplifier waveguide 612 may include an input end 612A and an output end 612B. The input end 612A of the amplifier waveguide 612 may refer to an input waveguide portion of the amplifier waveguide 612. The output end 612B of the amplifier waveguide 612 may refer to an output waveguide portion of the amplifier waveguide 612. In various embodiments, the input end 612A of the amplifier waveguide 612 may be angled with respect to the input facet 610A of the SOA 610 as illustrated in FIG. 6. In a further embodiment, the output end 612B of the amplifier waveguide 612 may be angled with respect to the output facet 610B of the SOA 610 as illustrated in FIG. 6. In such embodiments, the input end 612A and the output end 612B of the amplifier waveguide 612 may be angled waveguides. As such, in the first assembly configuration, the laser waveguide 608 of the gain chip 606 may be angled with respect to the rear facet 606A and straight and normal to the front facet 606B, while the SOA 610 may include an angled waveguide at its two facets, that is, the input facet 610A and the output facet 610B.

In the first assembly configuration, the output from the low reflection normal front facet 606B of the gain chip 606 may be coupled into the angled input of the SOA 610. That is, the output end 608B from the laser waveguide 608 of the gain chip 606 may be optically coupled into the angled input end 612A of the amplifier waveguide 612 of the SOA 610. In an embodiment, the two chips, that is, the gain chip 606 and the SOA 610 may be butt-coupled in close proximity to each other. In various embodiments, the gain chip 606 and the SOA 610 may be lens-coupled in close proximity to each other. In an example, microlenses may be utilized for optically coupling the output end 608B of the laser waveguide 608 of the gain chip 606 into the input end 612A of the amplifier waveguide 612 of the SOA 610. In various embodiments as illustrated in FIG. 6, the SOA 610 may be oriented with respect to the gain chip 606 such that an optical axis 620 of the gain chip 606 may be aligned to an input optical axis 622 of the SOA 610. The input optical axis 622 of the SOA 610 may refer to an optical axis of the input end 612A (or the input waveguide portion) of the amplifier waveguide 612. In such embodiments, the optical axis 620 of the gain chip 606 may be collinear with the input optical axis 622 of the SOA 610. To direct the light 616 emitted by the gain chip 606 into the input end 612A of the amplifier waveguide 612 of the SOA 610, the SOA 610 may be tilted to allow its input optical axis 622 to match with the optical axis 620 of the gain chip 606 from its low reflection normal front facet 606B. For example, due to the angled input end 612A of the amplifier waveguide 612, the SOA 610 may be tilted such that its input optical axis 622 matches with the optical axis 620 of the gain chip 606. In various embodiments, the angle of the input end 612A of the amplifier waveguide 612 may be configured to be small so that a tilt angle between the gain chip 606 and the SOA 610 may also be small to realize low loss optical coupling. Low loss optical coupling may allow coupling of the gain chip 606 to the SOA 610 with minimal loss of optical power to allow transfer of the light 616 from the gain chip 606 to the SOA 610 with high efficiency ensuring that a substantial portion of the light 616 may be preserved during the coupling process.

The gain chip-based ECL 602 may emit the light 616 having a narrow optical linewidth at an initial output power. The SOA 610 may receive, at the input facet 610A, the light 616 emitted by the gain chip-based ECL 602, amplify the received light 616 as the received light 616 propagates along the amplifier waveguide 612 of the SOA 610 from the input facet 610A to the output facet 610B, and emit, from the output facet 610B, an amplified light 618. The SOA 610 may control a resultant output power of the emitted amplified light 618 to a configurable level while maintaining the narrow optical linewidth in the emitted amplified light 618 constant. The SOA 610 may also maintain a lasing wavelength of the gain chip-based ECL 602 constant during the control of the resultant output power of the emitted amplified light 618 to the configurable level.

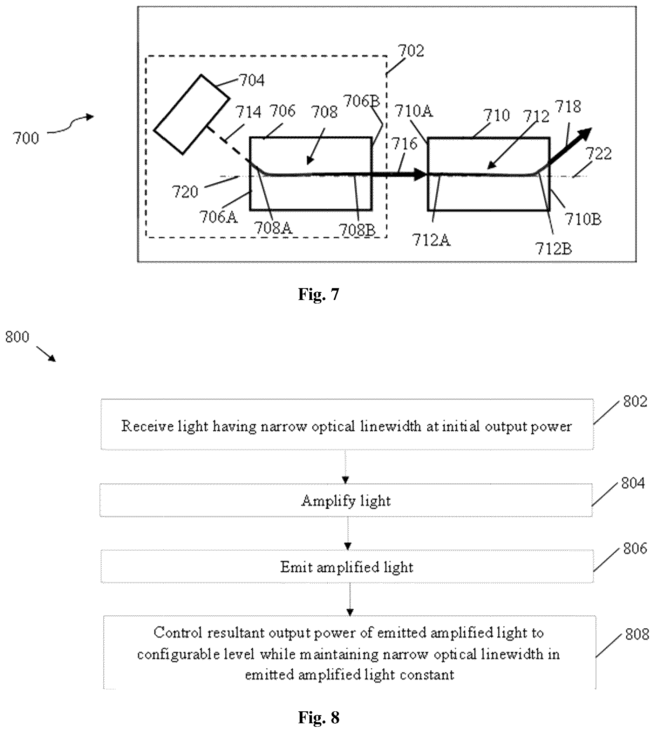

FIG. 7 is a diagram that illustrates an integrated device 700 including a gain chip-based ECL 702 and an SOA 710 arranged in a second assembly configuration, in accordance with an embodiment of the present disclosure. In an embodiment as illustrated in FIG. 7, the gain chip-based ECL 702 may include a reflector 704, for example, a mirror, in an external optical cavity and a gain chip 706. The external optical cavity may define an emission wavelength of the gain chip-based ECL 702 and assist in stabilizing and narrowing the optical linewidth of the laser output. The external optical cavity may further provide feedback to the gain chip 706 and can be adjusted to tune the laser output.

The gain chip-based ECL 702 may operate as a narrow linewidth laser source configured to emit a light 716 having a narrow optical linewidth at an initial output power. The gain chip 706 of the gain chip-based ECL 702 may include a rear facet 706A, a front facet 706B, and a laser waveguide 708 that extends from the rear facet 706A to the front facet 706B. In an embodiment, the laser waveguide 708 is substantially perpendicular to the rear facet 706A and the front facet 706B of the gain chip 706. The laser waveguide 708 may include a rear end 708A and an output end 708B. In an embodiment, the rear end 708A of the laser waveguide 708 may be angled with respect to the rear facet 706A of the gain chip 706 as illustrated in FIG. 7. In such an embodiment, the rear end 708A of the laser waveguide 708 may be an angled waveguide. In a further embodiment, the output end 708B of the laser waveguide 708 may be perpendicular to the front facet 706B of the gain chip 706 as illustrated in FIG. 7. In such an embodiment, the output end 708B of the laser waveguide 708 may be a straight waveguide.

The gain chip 706 of the gain chip-based ECL 702 may be integrated with the SOA 710 as illustrated in FIG. 7. In an embodiment, the gain chip 706 may be based on facet reflectivities of anti-reflection on the angled rear facet 706A and low-reflection on the normal front facet 706B. In a further embodiment, the gain chip-based ECL 702 is formed by coupling a light output 714 from the anti-reflection angled rear facet 706A of the gain chip 706 to the reflector 704. The light 716 may then emit from the low reflection normal front facet 706B of the gain chip 706 for coupling into the SOA 710.

Further, the SOA 710 may include an input facet 710A, an output facet 710B, and an amplifier waveguide 712 that extends from the input facet 710A to the output facet 710B. In an embodiment, the amplifier waveguide 712 is substantially perpendicular to the input facet 710A and the output facet 710B of the SOA 710. The amplifier waveguide 712 may include an input end 712A and an output end 712B. The input end 712A of the amplifier waveguide 712 may refer to an input waveguide portion of the amplifier waveguide 712. The output end 712B of the amplifier waveguide 712 may refer to an output waveguide portion of the amplifier waveguide 712. In various embodiments, the input end 712A of the amplifier waveguide 712 may be perpendicular to the input facet 710A of the SOA 710 as illustrated in FIG. 7. In such an embodiment, the input end 712A of the amplifier waveguide 712 may be a straight waveguide. In a further embodiment, the output end 712B of the amplifier waveguide 712 may be angled with respect to the output facet 710B of the SOA 710 as illustrated in FIG. 7. In such an embodiment, the output end 712B of the amplifier waveguide 712 may be an angled waveguide. As such, in the second assembly configuration, the laser waveguide 708 of the gain chip 706 may be angled with respect to the rear facet 706A and straight and normal to the front facet 706B, while the SOA 710 may include a straight waveguide at its input facet 710A and an angled waveguide at its output facet 710B.

In the second assembly configuration, the output from the low reflection normal front facet 706B of the gain chip 706 may be coupled into the straight input of the SOA 710. That is, the output end 708B from the laser waveguide 708 of the gain chip 706 may be optically coupled into the straight input end 712A of the amplifier waveguide 712 of the SOA 710. In various embodiments as illustrated in FIG. 7, the SOA 710 may be oriented with respect to the gain chip 706 such that an optical axis 720 of the gain chip 706 may be aligned with an input optical axis 722 of the SOA 710. The input optical axis 722 of the SOA 710 may refer to an optical axis of the input end 712A (or the input waveguide portion) of the amplifier waveguide 712. In such embodiments, the optical axis 720 of the gain chip 706 may be collinear with the input optical axis 722 of the SOA 710. In the second assembly configuration, the input end 712A of the amplifier waveguide 712 of the SOA 710 may be modified to be straight to allow the input end 712A to receive the light 716 from the gain chip 706 without any requirement of tilt of the SOA 710. In the second assembly configuration, there is no requirement to tilt the SOA 710 with respect to the gain chip 706 as both optical axes 720 and 722 of the chips are normal to their respective facets, that is, the front facet 706B and the input facet 710A. In an embodiment, the anti-reflection requirement of the input facet 710A of the SOA 710 is realized through an anti-reflection coating on the straight input facet 710A of the SOA 710.

The gain chip-based ECL 702 may emit the light 716 having a narrow optical linewidth at an initial output power. The SOA 710 may receive, at the input facet 710A, the light 716 emitted by the gain chip-based ECL 702, amplify the received light 716 as the received light 716 propagates along the amplifier waveguide 712 of the SOA 710 from the input facet 710A to the output facet 710B, and emit, from the output facet 710B, an amplified light 718. The SOA 710 may control a resultant output power of the emitted amplified light 718 to a configurable level while maintaining the narrow optical linewidth in the emitted amplified light 718 constant. The SOA 710 may also maintain a lasing wavelength of the gain chip-based ECL 702 constant during the control of the resultant output power of the emitted amplified light 718 to the configurable level.

It will be apparent to a person of ordinary skill in the art that various assembly configurations are shown in FIGS. 3-5A and FIGS. 6-7 for the sake of brevity. However, in various embodiments, other different assembly configurations may be implemented with different narrow linewidth lasers sources, optical amplifiers, and different structures of waveguides dedicated to similar or different functionalities.

FIG. 8 is a flowchart 800 that illustrates a method for controlling a resultant output power of an emitted amplified light 110 to a configurable level while maintaining a narrow optical linewidth in the emitted amplified light 110 constant, in accordance with an embodiment of the present disclosure. The flowchart 800 is described in conjunction with FIG. 1, FIGS. 3-5A, and FIGS. 6-7. At 802, the SOA 106 may receive light 108 having a narrow optical linewidth at an initial output power from a laser source, for example, a narrow linewidth laser source 104 such as a DFB laser 302, 402, or 502, a gain chip-based ECL 602 or 702, or the like. At 804, the SOA 106 may amplify the received light 108. At 806, the SOA 106 may emit the amplified light 110. At 808, the SOA 106 may control a resultant output power of the emitted amplified light 110 to a configurable level while maintaining the narrow optical linewidth in the emitted amplified light 110 constant. In an embodiment, the SOA 106 may also maintain a lasing wavelength of the laser source 104 constant during the control of the resultant output power of the emitted amplified light 110 to the configurable level.

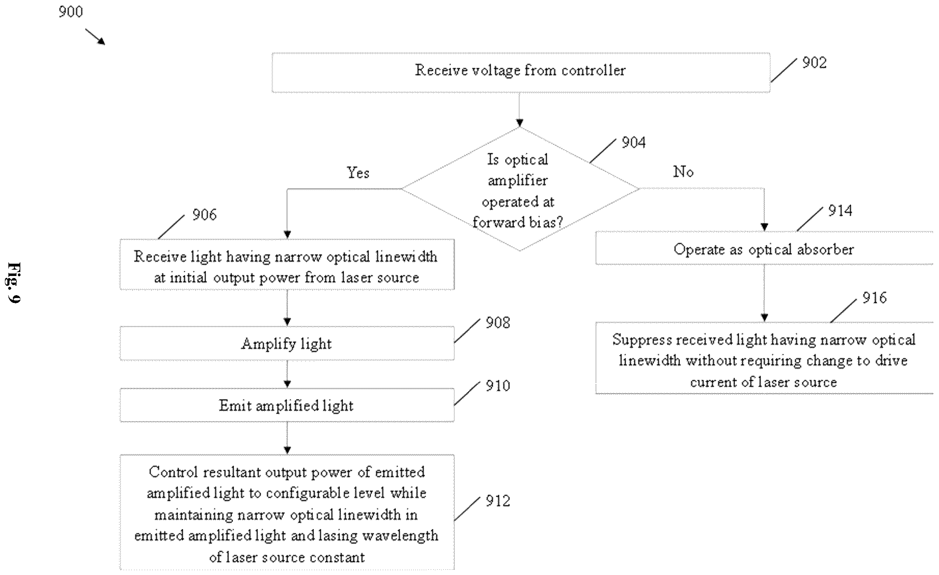

FIG. 9 is a flowchart 900 that illustrates an operation of an optical amplifier 106 in the integrated device 102 at a forward bias and a reverse bias, in accordance with an embodiment of the present disclosure. The flowchart 900 is described in conjunction with FIG. 1, FIGS. 3-5A, and FIGS. 6-7. At 902, an optical amplifier 106, for example, an SOA, may receive a voltage from a controller 114 operably coupled to the optical amplifier 106. At 904, it may be determined whether the optical amplifier 106 is operated at a forward bias. If the optical amplifier 106 is operated at a forward bias, at 906, the optical amplifier 106 may receive a light 108 having a narrow optical linewidth at an initial output power from a laser source, for example, a narrow linewidth laser source 104 such as a DFB laser 302, 402, or 502, a gain chip-based ECL 602 or 702, or the like. At 908, the optical amplifier 106 may amplify the received light 108. At 910, the optical amplifier 106 may emit the amplified light 110. At 912, the optical amplifier 106 may control a resultant output power of the emitted amplified light 110 to a configurable level while maintaining the narrow optical linewidth in the emitted amplified light 110 and a lasing wavelength of the laser source 104 constant. If the optical amplifier 106 is operated at a reverse bias, at 914, the optical amplifier 106 may operate as an optical absorber. At 916, the optical amplifier 106 may then suppress the received light 108 having the narrow optical linewidth without requiring a change to a drive current of the laser source 104. In an embodiment, a controller 114 is operably coupled to the optical amplifier 106 and configured to control a bias of the optical amplifier 106.

With the integration of the narrow linewidth laser source 104 with the optical amplifier 106 (interchangeably referred to as the "SOA 106"), in an embodiment, the SOA 106 may also implement an alternate function as a shutter or an on/off switch. When the SOA 106 is biased at 0 volts (V) or in reverse bias, the SOA 106 may serve as an optical absorber configured to substantially absorb or suppress the output light 108, thereby enabling an extinction of an output light 108 having a narrow optical linewidth without any change of the drive current to the narrow linewidth laser source 104. If the output of the narrow linewidth laser source 104 is cut off by switching off its drive current, the output may take some time to stabilize with the narrow optical linewidth when the narrow linewidth laser source 104 is switched on again. This time to establish a stable narrow optical linewidth may be eliminated in the integrated device 102 including the narrow linewidth laser source 104 with the SOA 106.

The present disclosure is best understood with reference to the detailed figures and description set forth herein. Various embodiments are discussed below with reference to the figures. However, those skilled in the art will readily appreciate that the detailed description provided herein with respect to the figures are merely for explanatory purposes as the methods and systems may extend beyond the described embodiments. In one example, the teachings presented and the needs of a particular application may yield multiple alternate and suitable approaches to implement the functionality of any detail described herein. Therefore, any approach may extend beyond the particular implementation choices in the following embodiments that are described and shown.

Techniques consistent with the disclosure provide, among other features, devices, and methods for controlling and stabilizing an output power of a narrow linewidth laser source 104 without any impact to a narrow optical linewidth and a lasing wavelength of the narrow linewidth laser source 104. While various embodiments of the disclosed devices and methods have been described above, it should be understood that they have been presented for purposes of example only, and not limitations. The foregoing examples and illustrative implementations of various embodiments have been provided merely for explanation and are in no way to be construed as limiting of the disclosure to the precise form disclosed. Further, although the embodiments are described herein with reference to particular means, materials, techniques, and implementations, the embodiments herein are not intended to be limited to the particulars disclosed herein; rather, the embodiments extend to all functionally equivalent structures, methods, and uses, such as are within the scope of the appended claims.

While the present disclosure is described with reference to various embodiments, it will be understood by those skilled in the art that various changes may be made, and equivalents may be substituted without departure from the scope of the present disclosure. In addition, many modifications and variations may be made to adapt a particular situation or material to the teachings of the present disclosure or may be acquired from practicing the disclosure, without departing from its scope. Therefore, it is intended that the present disclosure is not limited to the embodiments disclosed, but that the present disclosure will include all embodiments that fall within the scope of the appended claims.

## Claims

1. An integrated device, comprising:
a laser source configured to emit a light having a narrow optical linewidth at an initial output power; and
an optical amplifier operably coupled to the laser source, wherein the optical amplifier is configured to:
receive the light from the laser source;
amplify the received light;
emit the amplified light; and
control a resultant output power of the emitted amplified light to a configurable level while maintaining the narrow optical linewidth in the emitted amplified light constant.

2. The integrated device of claim 1, wherein the optical amplifier is a semiconductor optical amplifier.

3. The integrated device of claim 1, wherein the optical amplifier is further configured to maintain a lasing wavelength of the laser source constant during the control of the resultant output power of the emitted amplified light to the configurable level.

4. The integrated device of claim 1, wherein
the laser source comprises a laser waveguide that extends from a front facet to a rear facet of the laser source, and
the optical amplifier comprises an amplifier waveguide that extends from an input facet to an output facet of the optical amplifier.

5. The integrated device of claim 4, wherein the laser waveguide is substantially perpendicular to the front facet and the rear facet of the laser source.

6. The integrated device of claim 4, wherein the laser waveguide comprises:
a rear end configured to be perpendicular to the rear facet of the laser source; and
an output end configured to be perpendicular or angled with respect to the front facet of the laser source.

7. The integrated device of claim 6, wherein the output end of the laser waveguide is a straight active waveguide or a passive angled waveguide.

8. The integrated device of claim 7, wherein the passive angled waveguide is configured as a spot-size converter that aligns with an optical mode of the optical amplifier.

9. The integrated device of claim 4, wherein the amplifier waveguide is substantially perpendicular to the input facet and the output facet of the optical amplifier.

10. The integrated device of claim 4, wherein the amplifier waveguide comprises:
an input end configured to be perpendicular or angled with respect to the input facet of the optical amplifier; and
an output end configured to be angled with respect to the output facet of the optical amplifier.

11. The integrated device of claim 10, wherein the input end of the amplifier waveguide is a straight waveguide or an angled waveguide.

12. The integrated device of claim 10, further comprising an anti-reflection coating on the input end at the input facet of the optical amplifier and on the output end at the output facet of the optical amplifier.

13. The integrated device of claim 4, wherein an output end of the laser waveguide is optically coupled to an input end of the amplifier waveguide.

14. The integrated device of claim 4, wherein the optical amplifier is oriented with respect to the laser source such that an optical axis of the laser source is aligned with an input optical axis of the optical amplifier.

15. The integrated device of claim 14, wherein the optical axis of the laser source is collinear with the input optical axis of the optical amplifier.

16. The integrated device of claim 1, further comprising at least one controller operably coupled to the laser source, wherein the at least one controller is configured to control an applied drive current that maintains the initial output power of the light.

17. The integrated device of claim 1, further comprising at least one controller operably coupled to the optical amplifier, wherein the at least one controller is configured to vary an optical gain of the optical amplifier to amplify the initial output power of the light from the laser source and stabilize the resultant output power to the configurable level.

18. The integrated device of claim 1, wherein the optical amplifier is further configured to adjust an optical power drift from the initial output power of the light from the laser source during the control of the resultant output power of the emitted amplified light to the configurable level.

19. The integrated device of claim 1, wherein the laser source is a narrow linewidth laser source selected from a group comprising a distributed feedback laser and a gain chip-based external cavity laser.

20. An integrated device, comprising:
a laser source configured to emit a light having a narrow optical linewidth at an initial output power; and
an optical amplifier operably coupled to the laser source, the optical amplifier being operable with a reverse bias and a forward bias, wherein
based on operation with the forward bias, the optical amplifier is configured to:
receive the light from the laser source;
amplify the received light;
emit the amplified light; and
control a resultant output power of the emitted amplified light to a configurable level while maintaining the narrow optical linewidth in the emitted amplified light constant; and
based on operation with the reverse bias, the optical amplifier is configured to:
operate as an optical absorber; and
suppress the received light having the narrow optical linewidth without requiring a change to a drive current of the laser source.
